# EUROPEAN PATENT APPLICATION

(11) **EP 2 830 087 A1**
(43) Date of publication of application: **28.01.2015**
(21) Application number: 13178163.5
(22) Date of filing: 26.07.2013
(51) Int. Cl.: H01L 21/60

(54) **Method for interconnection of electrical components on a substrate**

(71) Applicant: Hamilton Sundstrand Corporation, Charlotte, NC 28217 (US)
(72) Inventor: Seidel, Rainer J., 86874 Tussenhausen (DE); Gerhaeusser, Thomas E., 91747 Westheim (DE)
(74) Representative: Bridge, Kerry Ann

(57) **Abstract**

A method is described for interconnecting first, 27, and second, 22, components on a substrate, 21. The comprises attaching said first component, 27, to said substrate, attaching said second component, 22, to said substrate, 21, said first and second components being positioned relative to each other on said substrate to form a gap, 31, therebetween. The method further comprises the step of depositing a layer, 24, of electrically insulating material in said gap, and electrically connecting said first component, 27, with said second component, 22, by depositing, upon said electrically insulating layer, a layer of electrically conducting material, 26, which is in contact with and extends from a surface of said first electronic component, across said gap, 31, and said layer of electrically insulating material, 24, and to a surface of said second electronic component, 22. The method is characterised in that a plasma deposition process is used to deposit at least one of said layers of material.

## Description

### FIELD OF TECHNOLOGY

A new method for interconnecting a first component with a second component on a substrate is herein described. In particular, a new method for interconnecting a first electronic component such as a bare semiconductor die with the surrounding circuitry is herein described.

### BACKGROUND

Electronic components such as semiconductor dies as e.g. Silicon power MOSFET dies are typically interconnected with the surrounding circuitry using bond-wires made from gold or, for thicker diameters, from aluminium. To carry high currents, usually several bond-wires are installed in parallel to reduce the electrical resistance.

### SUMMARY

A method for interconnecting first and second components on a substrate is described herein which comprises attaching said first component to said substrate, attaching said second component to said substrate, said first and second components being positioned relative to each other on said substrate to form a gap therebetween, said method further comprising the step of depositing a layer of electrically insulating material in said gap, and electrically connecting said first component with said second component by depositing, upon said electrically insulating layer, a layer of electrically conducting material which is in contact with and extends from a surface of said first electronic component, across said gap and said layer of electrically insulating material and to a surface of said second electronic component, said method **characterised in that** a plasma deposition process is used to deposit at least one of said layers of material.

In some embodiments described herein, the first component may have a first surface attached to said substrate, and an opposing second surface and a side surface extending therebetween, and said step of depositing said layer of electrically insulating material in said gap may further comprises depositing said layer of electrically insulating material so that it contacts at least a portion of said side surface of said first component.

In some embodiments described herein, the step of depositing said layer of electrically insulating material may comprise depositing said layer of electrically insulating material so that it also contacts said second surface of said first component.

In some embodiments described herein, the step of attaching said first component, to said surface of said substrate may comprise soldering, sintering, nanofoil bonding or attaching with an electrically conductive glue said first component to said substrate.

In some embodiments described herein, the step of attaching said first component to said substrate may produce an attachment layer between said substrate and said first component and said step of depositing said layer of electrically insulating material may comprise depositing said layer of electrically insulating material upon at least a part of said attachment layer.

In some embodiments described herein, the step of depositing said layer of electrically insulating material may comprise depositing the layer of electrically insulating material around the entire outer perimeter of the first component.

In some embodiments described herein, following said step of depositing said layer of electrically conductive material, the method may further comprise the step of encapsulating said interconnected first and second components.

Encapsulating materials and processes may comprise epoxies, silicones or urethanes. These may be either unfilled or filled and applied through potting.

In some embodiments described herein, said step of encapsulating may comprise depositing a second layer of insulating material upon said electrically conductive layer.

In some embodiments described herein, said first layer of electrically insulating material and said second layer of electrically insulating material may comprise the same material.

In some embodiments described herein, said first layer of electrically insulating material may comprise a first insulating material and said second layer of insulating material may comprise a second insulating material, which is different to said first insulating material.

In some embodiments described herein, said insulating layer(s) and/or said electrically conducting layer may be planar.

In another embodiment described herein, the method may comprise the step of, following said deposition of said electrically conducting layer, depositing a second layer of insulating material over said electrically conductive layer.

In some embodiments, the first insulating layer and the second insulating layer may comprise the same material.

In other embodiments, the first insulating layer may comprise a first insulating material and the second insulating layer may comprise a second insulating material, different to the first insulating material.

The methods described herein may use copper as the electrically conducting material, however, other materials may also be used.

In some embodiments described herein, the first electronic component may be a semiconductor die.

In some embodiments described herein, said second electronic component may be a contact pad.

The methods described herein may use a glass, ceramic or organic compound as the insulating material. Other insulating materials may also be used.

### BRIEF DESCRIPTION OF THE DRAWINGS

Figure 1 shows the cross section through a standard wire-bonded assembly as is currently known in the field of semiconductor dies.
Figure 2 shows a cross section through an assembly produced via the new method as described herein.
Figure 3 shows an aerial view of four stages of a method as described herein for electrically interconnecting components on a substrate.

### DETAILED DESCRIPTION

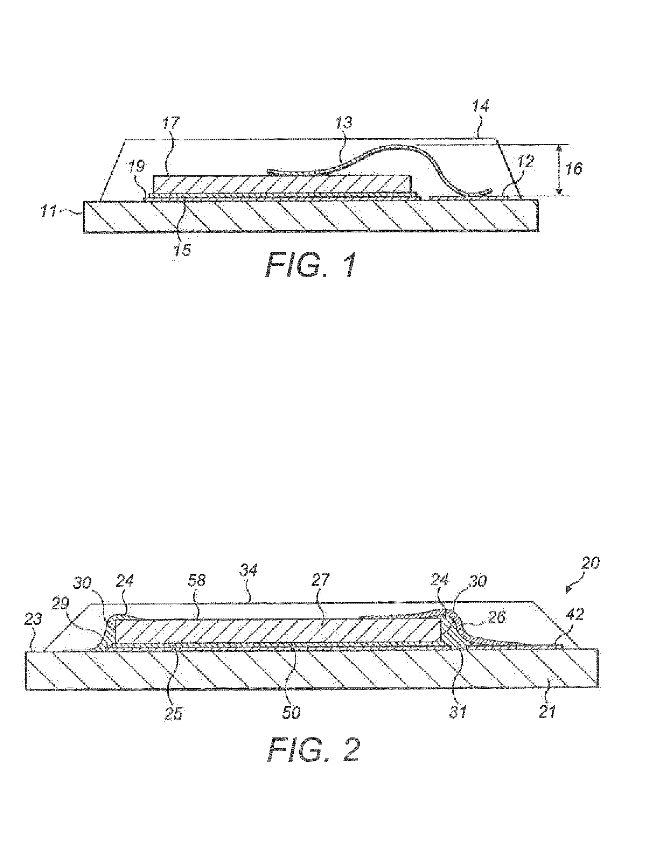

Electronic components, such as semiconductor dies, 17, (e.g. Silicon power MOSFET dies), provided on and attached (e.g. via a solder layer) to a substrate, 11, are typically interconnected with the surrounding electronic components and circuitry, 12, using bond-wires, 13, made from gold or, for thicker diameters, from aluminium. As is seen in figure 1, which depicts a known assembly, the silicon semiconductor die, 17, is initially soldered via a solder layer, 15, to a layer of copper, 19, on the substrate, or baseplate, 11, and the bond-wires, 13, then connect this to the surrounding circuitry, 12, (e.g. a contact pad). To carry high currents, usually several bond-wires are installed in parallel to reduce the electrical resistance. An example of this is shown in Figure 1, which depicts the cross section through a standard wire-bonded assembly (only one bond-wire is shown). The silicon die and surrounding circuitry is then encapsulated using one or two component epoxy materials.

In such known methods, the bond-wire shape with its minimum loop height, 16, therefore defines the thickness of the required encapsulation, 14, that is usually needed to protect the wire, 13, itself and the fragile semiconductor surface. The amount of necessary encapsulation material increases the weight and the size of the component. The bonding process itself needs expensive tooling, especially when bonding many dies on large boards with chip-on-board (COB) technology. Applying the bond and encapsulation processes to a board using double sided COB technology is even more complex. In addition, thermo-mechanical forces between the encapsulation material, the silicon, the bond-wire and the baseplate have to be taken into account.

The new method described herein uses a totally different approach to establish the interconnection between components on a substrate. The new method allows for the interconnection of components on a substrate, such as the interconnection of a bare semiconductor die such as a MOSFET die with the surrounding circuitry whilst overcoming the disadvantages associated with known techniques.

In particular, in the methods described herein, a plasma deposition technology may be used to form layers of insulating materials as well as current conducting materials on top of each other. The plasma deposition technology may use raw materials in the form of a nano- or micro-powder, that is melted and then accelerated in a low power plasma before being deposited as a coating on the substrate, as is known in the art. A plasma deposition process that may be used for depositing the insulating and/or conducting materials onto the substrate may comprise the use of a Micro Cold Plasma deposition process (MCP) as is known in the art. This type of plasma deposition method combines the advantages of conventional sputtering with high deposition of thermal spraying.

The operating conditions and parameters of such systems and processes can be set according to requirements, based on the materials used and the coating required. Such systems may be used on an industrial scale, for automated deposition of plasma onto a substrate.

This method is capable of producing planar layers from a few microns to fractions of a millimetre in thickness with a minimum structure width of 1-2mm. This plasma deposition method has already been implemented in the solar cell industry, and has proven to be compatible with clean room conditions and semiconductor processes.

Figure 2 shows a cross section through an assembly, 20, that has been produced via the new method as described herein. As can be seen in Figure 2, a first component, 27, which in this embodiment is an electronic component, i.e. a semiconductor die, 27, is provided on a first surface, 23, of a substrate such as a baseplate, 21. In some embodiments, the substrate, 21, may be a printed wiring board (PWB).

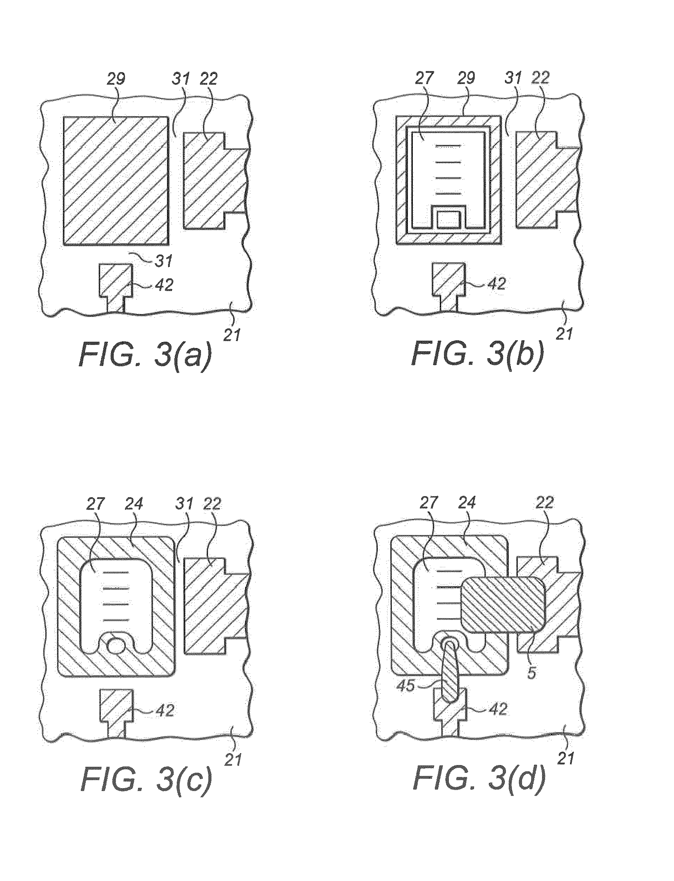

Figure 3 shows different stages in a method for producing an assembly such as that shown in figure 2. Figure 3(a) depicts a printed wiring board, 21, wherein a plurality of layers having conductive properties (in this example, these comprise three copper layers, 22, 29, 42, which act as contact pads) have been deposited onto the surface of the substrate with gaps, 31, separating the contact pads, 29, 22, 42, from each other. This may be achieved by additive (e.g. vibro-welding) or subtractive (etching) methods.

In the embodiment shown in figure 3(b), an electronic component, such as a semiconductor die, 27, is then positioned on one of those copper layers, 29, and attached thereto, (and to the PWB) via soldering. This step of attaching may produce an attachment layer, 25, as shown in figure 2. In this embodiment, the attachment layer extends between the substrate, 21, and the semiconductor die, 27, and further extends outwards into the gap, 31, slightly at the side, 30, of the die, 27. Other techniques such as sintering, nanofoil bonding or the use of a conductive glue may alternatively be used for attaching the semiconductor to the PWB.

After the semiconductor die, 27, has been attached to the PWB, the new method for interconnecting this die to surrounding components involves using the above-described plasma deposition process to deposit a first planar layer of an insulating material, 24, (e.g. glass, ceramic or organic compound, or any other insulating material) at least in the gap, 31, that is provided between the components, for example the gap, 31, between the semiconductor die, 27, and the contact pad, 22 as shown in figure 3(c).

In some embodiments, the first component (i.e. the semiconductor die, 27), has a first surface, 50, attached to the substrate, 21, an opposing second surface, 58, and a side surface, 30, extending therebetween. In these embodiments, the step of depositing the layer of electrically insulating material, 24, in the gap, 31, further comprises depositing the layer of electrically insulating material, 24, so that it contacts at least a portion of the side surface, 30, of the first component 27. This can be seen in figures 2 and 3.

In figures 2 and 3, it can also be seen that this step of depositing the layer of electrically insulating material, 24, may comprise the step of depositing the layer of electrically insulating material, 24, so that it also contacts the second, i.e. upper surface, 58, of the semiconductor die, 27.

In some embodiments, such as that shown in figures 2 and 3, the step of depositing the layer of electrically insulating material, 24, may also comprise the step of depositing the layer of electrically insulating material, 24, upon at least a part of the underlying attachment layer, 25, as well as the underlying copper layer, 29.

In some embodiments, the insulating layer may be deposited so that it covers at least a portion of the outer perimeter or edge of the semiconductor die, 27. An example of this is shown in figure 3(c) wherein a layer of an insulating material, 24, is deposited via the above described plasma deposition process onto the upper, 58, and side, 30, edges or surfaces of the die, 27, so that it extends on and around the entire outer perimeter and side surface of the semiconductor die. In this embodiment, the insulating layer, 24, also covers the underlying copper layer, 29, and attachment layer, 25, and extends into the gap, 31. In the embodiment of figure 2, it extends further to contact the contact pad, 22, however, this is not the case for the embodiment shown in figure 3, wherein the insulating layer terminates in the gap, 31.

In the embodiment shown in figures 2 and 3, wherein the insulating layer, 24, covers the side surface, 30, of the die, 27, as well as at least part of the attachment layer, 25, that attaches the die, 27, to the baseplate, this insulating layer acts to protect both the edge, 30, 58, or perimeter of the die, 27, and the underlying attachment layer, 25, from contact with the conducting layer, 26, which is deposited in the next stage.

Following this insulating step, a layer of an electrically conducting material, e.g. copper, 26, is deposited over one or more sections of the die that comprise the insulating material provided thereon, as described above. The conducting material is deposited so that it extends from and contacts the die, (in the embodiment shown in figure 2 it is the uppermost, or top surface, 58, of the die, i.e. the opposing surface of the die to which the baseplate is attached). The conducting layer, 26, then further extends from the semiconductor die, 27, and across the underlying insulating layer, 24, before contacting the second component, 22 (or other surrounding circuitry). This thereby provides an electrical connection from the first component, and in the embodiment shown in figure 2, from the die's top surface, 58, to the surrounding circuitry, 22, e.g. a contact pad.

In some embodiments, this step of providing a conducting layer may be repeated in the case where more than one connection is needed, to thereby provide a plurality of electrical connections or channels. This is depicted in figure 3(d), which shows a source connection, 5, between the semiconductor, 27, and the contact pad, 22, and a gate connection, 45, between the semiconductor, 27, and the contact pad, 42.

As seen in figure 3, in some embodiments, the insulating layer may therefore extend around the entire perimeter of the semiconductor die (to thereby protect the edge of the die) and a plurality of individual conducting layers may extend from the top surface of the die to each of the surrounding electronic components.

In other embodiments, however, (not shown) the insulating layer may only be provided at the places where the electrical connections are to be made. The electrical connection to the second component therefore act as a kind of channel which extends between the components. Further embodiments may also comprise a plurality of such channel like connections.

Finally, an encapsulation process may be applied as is known in the art. Encapsulating materials may comprise epoxies, silicones or urethanes. These may be either unfilled or filled and applied through potting. In other embodiments, however, this encapsulation step may be replaced by the deposition of an additional planar layer, 34, of an insulating material deposited on top of the electrically conductive layer, as is shown in figure 2. Again, the same plasma deposition techniques as described earlier may be used. In some embodiments, the layer could be soft for thermo-mechanical robustness and/or non-transparent to protect the die against light passing into the junction etc.

The whole process described herein may be implemented in a computer automated machine with moving plasma jets for each needed material, supported by a vision system to detect the correct coordinates on the dies. COB boards can be automatically fed in and out of the machine.

The new method described herein has significant advantages over known methods. For example, by replacing discrete bond-wires with planar layers, electrical resistance is reduced and the parasitic inductance of the connection is positively influenced. Even a part delamination of the conducting layer would not interrupt the connection, whereas in contrast to this, a loose bond-wire can cause a totally failed circuit. As is quite clearly seen by comparing figures 1 and 2, the overall thickness of the assembly produced via the method described herein is greatly reduced. Reducing the overall thickness of the assembly also reduces the weight and size, particularly in the case wherein the encapsulation layer is plasma deposited as well.

For large COB boards, the packaging density will increase, and the technology may even allow for COB double sided on the boards.

In terms of production, the cost will be decreased, as simple glass / copper powder is used instead of costly bond wires. No machine shutdown is necessary to change bond-wired of different diameters or materials. In addition to this, the curing of the encapsulation material (in a range of several hours per side) becomes totally obsolete. A further advantage is that the same method / equipment could be used for additional deposition processes.

The packaging size is also reduced in area and height compared to standard techniques. Due to the omission of wire bond loops, the package encapsulation is thinned down which results in better thermal conditions for the power MOSFET die.

As there is no shear force on wire bonds, there are less requirements regarding the encapsulation process. Perfectly matched materials promise to show higher reliability than standard methods that would increase the value of boards for the customer.

## Claims

1. A method for interconnecting first (27) and second (22) components on a substrate (21),
attaching said first component (27) to said substrate,
attaching said second component (22) to said substrate (21), said first and second components being positioned relative to each other on said substrate to form a gap (31) therebetween, said method further comprising the step of
depositing a layer (24) of electrically insulating material in said gap, and electrically connecting said first component (27) with said second component (22) by depositing, upon said electrically insulating layer, a layer of electrically conducting material (26) which is in contact with and extends from a surface of said first electronic component, across said gap (31) and said layer of electrically insulating material (24) and to a surface of said second electronic component (22),
said method **characterised in that** a plasma deposition process is used to deposit at least one of said layers of material.

2. The method of claim 1 wherein said first component (27) has a first surface (50) attached to said substrate (21), and an opposing second surface (58) and a side surface (30) extending therebetween, and wherein said step of depositing said layer of electrically insulating material (24) in said gap (31) further comprises depositing said layer of electrically insulating material (24) so that it contacts at least a portion of said side surface (30) of said first component (27).

3. The method of claim 2 wherein the step of depositing said layer of electrically insulating material (24) comprises depositing said layer of electrically insulating material (24) so that it also contacts said second surface (58) of said first component.

4. The method of any preceding claim wherein the step of attaching said first component, (27), to said surface of said substrate, (21), comprises soldering, sintering, nanofoil bonding or attaching with an electrically conductive glue said first component to said substrate (21).

5. The method of any preceding claim wherein said step of attaching said first component (27) to said substrate (21) produces an attachment layer (25) between said substrate (21) and said first component (27) and wherein said step of depositing said layer of electrically insulating material (24) comprises depositing said layer of electrically insulating material (24) upon at least a part of said attachment layer (25).

6. The method of any preceding claim wherein the step of depositing said layer of electrically insulating material (24) comprises depositing the layer of electrically insulating material (24) around the entire outer perimeter of the first component (27).

7. The method of any preceding claim comprising the step of, following said step of depositing said layer of electrically conductive material (26), encapsulating (34) said interconnected first (27) and second (22) components.

8. The method of claim 7 wherein said step of encapsulating comprises depositing a second layer of insulating material (34) upon said electrically conductive layer (26).

9. The method of claim 8 wherein said first layer of electrically insulating material (24) and said second layer of electrically insulating material (34) comprise the same material.

10. The method of claim 8 wherein said first layer of electrically insulating material (24) comprises a first insulating material and said second layer of insulating material (34) comprises a second insulating material, which is different to said first insulating material.

11. The method of any preceding claim wherein said first component is a semiconductor die (27).

12. The method of any preceding claim wherein said second component is a contact pad (22).

13. The method of any preceding claim wherein said insulating layer(s) and/or said electrically conducting layer are planar.

14. The method of any preceding claim wherein said layer(s) of electrically insulating material comprises a glass, ceramic or organic compound.

15. The method of any preceding claim wherein said layer of electrically conducting material (26) comprises copper.

## Amended claims

### Amended claims in accordance with Rule 137(2) EPC.

**1.** A method for interconnecting first (27) and second (22) components on a substrate (21),
attaching said first component (27) to said substrate,
attaching said second component (22) to said substrate (21), said first and second components being positioned relative to each other on said substrate to form a gap (31) therebetween, said method further comprising the step of
depositing a layer (24) of electrically insulating material in said gap, and
electrically connecting said first component (27) with said second component (22) by depositing, upon said electrically insulating layer, a layer of electrically conducting material (26) which is in contact with and extends from a surface of said first electronic component, across said gap (31) and said layer of electrically insulating material (24) and to a surface of said second electronic component (22),
said method **characterised in that** a plasma deposition process is used to deposit said layer of insulating material and said layer of electrically conducting material.

**2.** The method of claim 1 wherein said first component (27) has a first surface (50) attached to said substrate (21), and an opposing second surface (58) and a side surface (30) extending therebetween, and wherein said step of depositing said layer of electrically insulating material (24) in said gap (31) further comprises depositing said layer of electrically insulating material (24) so that it contacts at least a portion of said side surface (30) of said first component (27).

**3.** The method of claim 2 wherein the step of depositing said layer of electrically insulating material (24) comprises depositing said layer of electrically insulating material (24) so that it also contacts said second surface (58) of said first component.

**4.** The method of any preceding claim wherein the step of attaching said first component, (27), to said surface of said substrate, (21), comprises soldering, sintering, Nanofoil® bonding or attaching with an electrically conductive glue said first component to said substrate (21).

**5.** The method of any preceding claim wherein said step of attaching said first component (27) to said substrate (21) produces an attachment layer (25) between said substrate (21) and said first component (27) and wherein said step of depositing said layer of electrically insulating material (24) comprises depositing said layer of electrically insulating material (24) upon at least a part of said attachment layer (25).

**6.** The method of any preceding claim wherein the step of depositing said layer of electrically insulating material (24) comprises depositing the layer of electrically insulating material (24) around the entire outer perimeter of the first component (27).

**7.** The method of any preceding claim comprising the step of, following said step of depositing said layer of electrically conductive material (26), encapsulating (34) said interconnected first (27) and second (22) components.

**8.** The method of claim 7 wherein said step of encapsulating comprises depositing a second layer of insulating material (34) upon said electrically conductive layer (26).

**9.** The method of claim 8 wherein said first layer of electrically insulating material (24) and said second layer of electrically insulating material (34) comprise the same material.

**10.** The method of claim 8 wherein said first layer of electrically insulating material (24) comprises a first insulating material and said second layer of insulating material (34) comprises a second insulating material, which is different to said first insulating material.

**11.** The method of any preceding claim wherein said first component is a semiconductor die (27).

**12.** The method of any preceding claim wherein said second component is a contact pad (22).

**13.** The method of any preceding claim wherein said insulating layer(s) and/or said electrically conducting layer are planar.

**14.** The method of any preceding claim wherein said layer(s) of electrically insulating material comprises a glass, ceramic or organic compound.

**15.** The method of any preceding claim wherein said layer of electrically conducting material (26) comprises copper.
